# EUROPÄISCHE PATENTSCHRIFT

(11) **EP 1 736 324 B1**
(45) Veröffentlichungstag und Bekanntmachung des Hinweises auf die Patenterteilung: **31.10.2012**
(21) Anmeldenummer: 06013064.8
(22) Anmeldetag: 24.06.2006
(51) Int. Cl.: H05K 3/04, B44C 1/14

(54) **Verfahren zum Herstellen eines Dekors oder optischen Sicherheitsmerkmals aus einer metallischen oder metallisierten Folie auf einem Substrat**
Process for providing a decor or a security feature from a metallic or metallized film on a substrate
Procédé pour appliquer un décor ou un élément de sécurité d'une feuille métallique ou métallisée sur un substrat

(30) Priorität: 25.06.2005 DE 102005029640
(43) Veröffentlichungstag der Anmeldung: 27.12.2006
(73) Patentinhaber: Eforma, 8152 Glattbrugg (CH)
(72) Erfinder: Schneider, Gerhard, 8353 Elgg (CH)
(74) Vertreter: Patentanwälte Bitterich, Dr. Keller, Schwertfeger

(56) Entgegenhaltungen:
- EP-A- 0 414 362
- WO-A-03/020519
- DE-C1- 4 440 762
- GB-A- 2 368 313

## Beschreibung

Die Erfindung betrifft ein Verfahren zum Herstellen eines Dekors oder optischen Sicherheitsmerkmals aus einer metallischen oder metallisierten Folie auf einem Substrat gemäß dem Oberbegriff des Patentanspruchs 1.

Ein Hauptanwendungsgebiet der Erfindung besteht in dem Aufbringen von Dekors und optischen Sicherheitsmerkmalen auf Produkt- oder Verpackungsoberflächen durch ein digitales Druckverfahren.

Zur Herstellung von Dekors werden vor allem metallisierte Folien, beispielsweise Silber- oder Goldlolien, eingesetzt. Deren Glanzeffekt zieht das Augenmerk des Verbrauchers auf sich und erweckt bei diesem den Eindruck, ein qualitativ hochwertiges Produkt vor sich zu haben. Bei Sicherheitsmerkmalen, beispielsweise in Form von Hologrammen, steht hingegen der Schutz vor unerlaubten Nachbildungen im Vordergrund. Diese dienen den Herstellern von Markenprodukten dazu, die Echtheit ihrer Produkte dem Verbraucher zu garantieren. Optische Sichorheitsmerkmale erschweren den Raubkopierern das Herstellen von Fälschungen ganz erheblich.

Zur Aufbringung eines Dekors oder eines optischen Sicherheitsmerkmals auf eine Substratoberfläche ist seit vielen Jahren das Heißprägeverfahren bekannt (vgl. zum Beispiel DE 42 40 817, DE 196 04 741). Dabei wird eine Prägefolle im Bereich des herzustellenden Musters örtlich auf ein Substrat, beispielsweise eine Produkt- oder Verpackungsoberfläche aufgebracht. Die Prägefolie setzt sich aus einer Trägerfolie zusammen, die an ihrer dem Substrat zugewandten Seite mit einer metallisierten Folie beschichtet ist. Die metallisierte Folie ist wiederum mit einem thermisch aktivierbaren Haftvermittler großflächig bedeckt. Zur Vorbereitung des Prägevorgangs werden Substrat und Prägefolie einander zugeführt und deckungsgleich übereinander gelegt. Anschließend applizieren beheizte Prägewerkzeuge das herzustellende Muster oder Dekor auf das Substrat, indem das Prägewerkzeug von der Rückseite der Trägerfolie die metallisierte Folie in bestimmten Bereichen unter Anwendung von Temperaturen von 100 C° bis 230 C° gegen das Substrat drückt. Infolge der stellenweise honen Temperaturen wird der Kleber im Bereich des Musters oder Dekors aktiviert, so dass im Bereich der Prägung eine Verklebung der metallisierten Folie mit dem Substrat erfolgt. Bereiche daneben bleiben ohne Verbund. Mit dem anschließenden Abheben der Prägefolie vorn Substrat reißt die metallisierte Folie infolge ihrer spröden Eigenschaft am Kleberand des Musters oder Dekors, das dadurch in der gewünschten Form auf dem Substrat zurückbleibt.

Der Nachteil des Heißprägeverfahrens liegt vor allem in der Notwendigkeit, ein Verkleben der metallisierten Folie mit dem Substrat unter Einwirkung von Hitze zu erreichen. Neben dorn damit verbundenen gerätetechnischen Aufwand für das Beheizen des Prägewerkzeugs ist damit das Veredeln temperaturempfindlicher Oberflächen ausgeschlossen.

Aus diesem Grund ist für bestimmte Anwendungen neben dem Heißprägeverfahren das Kaltprägeverfahren verbreitet. Bei diesem Verfahren wird das Substrat mit einem mit UV-Licht aktivierbaren Haftvermittler bedruckt, beispielsweise im Rotationsdruck. Der Druck entspricht dabei der Form des herzustellenden Musters. Anschließend wird das so vorbereitete Substrat mit einer Prägefolie zusammengeführt, die sich in diesem Fall lediglich aus einer Trägerfolie und einer metallisierten Folie zusammensetzt. Über eine Anpresswalze wird die Prägefolie unter Kontakt auf das Substrat gedrückt. Anschließend wird der Haftvermittler durch Bestrahlung mit UV-Licht aktiviert, wodurch es zu einem Zusammenkleben der Trägerfolie und des Substrats im Bereich des Kraftvermittlers kommt. Durch anschließendes Abheben der Prägefolie vom Substrat reißt lediglich die spröde metallisierte Folie am Kleberand, so dass diese im Bereich des herzustellenden Musters auf dem Substrat zurückbleibt. Diese beiden Verfahren haben sich bei der Veredelung von Produkt- und Verpackungsoberflächen bewährt, sind jedoch nur bei hohen Stückzahlen wirtschaftlich sinnvoll anzuwenden. Bei Kleineren Serien oder gar Einzelentwürfen im Vorfeld einer Großproduktion schlagen die hohen Kosten für die Herstellung der Prägewerkzeuge bzw. Druckwerkzeuge durch, so dass in solchen Fällen eine wirtschaftlich vertretbare Anwendung dieser beiden Verfahren in Frage gestellt ist.

Ein anderes Anwendungsgebiet betrifft die Herstetlung elektronischer Bauteile. Beispielsweise müssen bei Transponderanwendungen der Mikroprozessor auf einem Untergrund angebracht und an eine Antenne angeschlossen werden. Dies geschieht üblicherweise mit Hilfe von Platinen, auf die ein Mikroprozessor gelötet und mittels geätzter Leiterbahnen angeschlossen wird. Obwohl hier der Automatisierungsgrad bereits beträchtlich fortgeschritten ist, ist diese Vorgehensweise dennoch umständlich und entsprechend kostenintensiv. Darüber hinaus ist dieses Verfahren auf elektronische Bauteile gleicher Architektur festgelegt, woraus sich dessen Eignung zur Herstellung großer Stückzahlen ergibt. Kleinere Serien lassen sich auf diese Weise nicht wirtschaftlich realisieren.

Ein Kerngedanke liegt darin, dass ein mittels UV.Licht aktivierbarer Haftvermittler bereichsweise und passerhaltig mit dem herzustellenden Muster auf die Oberfläche eines Substrats mit Hilfe eines digitalen Druckverfahrens aufgebracht wird. Digitale Druckverfahren sind schon seit längerem, beispielsweise aus der Xerographie, als konventionelles Trockentonerverfahren und aus dern InkJet-Druck, als konventionelles Tintendruckverfahren bekannt. Diese digitalen Druckverfahren zielen allerdings oft darauf ab, Druckerzeugnisse mit variablen Inhalten herzustellen. Auf dieso Weise werden beispielsweise Umschläge mit lesbaren Informationen beschriftet, und maschinenlesbare Informationen auf Postpaketen als Routenlabel für Paketdienste oder für Vorsicherungspolicen aufgedruckt.

In der DE 25 55 087 wird beispielsweise ein Verfahren zum Herstellen eines metallischen Überzuges mit Spiegelglanz auf einem Blatt oder eine Folie beschrieben. Das Verfahren basiert auf einem Lösungsmittel, das notwendlg ist, um die Vernetzung oder Härtung des Haftvermittlers einzuleiten. Als Haftvermittler dient ein speziell aufgetragener Klebstoff oder Lasurfilm. Der Haftvermittler wird bei diesem konventionellen Prägeverfahren in analoger Weise aufgetragen. Eine digitale Auftragung des Haftvermittlers wird nicht erwähnt.

In der DE 29 07 186 wird ein Verfahren zur Herstellung eines Metallüberzuges auf einem Träger beschrieben. Bei dem Verfahren wird eine Folie zusammen mit einem Kleber auf einen Träger aufgebracht und für längere Zeit liegen gelassen, um das Lösungsmittel ausgasen zu lassen. Ein digitales Verfahren zum Auftragen des Lackes als Haftvermittler wird nicht erwähnt.

In der DE 42 40 817 wird ein Verfahren zur Herstellung einer beschichteten Trägerplatte unter Verwendung eines Siebdruckverfahrens beschrieben. Hierbei erfolgt eine Überdruckung von Acrylglas mit einem Heißsiegellack. Anschließend wird auf diese Lackschicht eine matallische Prägefolie aufgeprägt, wodurch die metallfarbige Schicht in den mit Heißsiegellack versehenen Bereichen auf der Trägerplatte haften bleibt, so dass schließlich die Trägerfolie von der Trägerplatte abgezogen werden kann. Auch hier erfolgt das Auftragen des Haftvermittlers mittels eines analogen Auftrageverfahrens.

In der DE 196 04 741 wird ein Verfahren zum selektiven, bereichsweisen Beschichten einer Glasplatte mit einer Metallfolie beschrieben. Zum Aufbringen der Haftschicht wird ein (analoges) Siebdruckverfahren verwendet.

In der DE 36 16 081 wird ein anderes Verfahren beschrieben, das sich von den zuvor beschriebenen Verfahren unterscheidet. Der Haftvermittler wird bei diesem Verfahren auf eine Metallschicht und nicht auf das Substrat aufgetragen. Die oben beschriebenen Verfahren brachten den Haftvermittler direkt auf das Substrat auf und erst im nachfolgenden Schritt wurde die metallisierte Folie aufgeprägt. In dieser Offenlegungsschrift wird der Heißschmelzkleber bzw. Binder auf die Metallseite einer metallisierten Folie in gegebenenfalls mittels Schablone ausgewählten Bereichen oder vollflächig aufgebracht, so dass die mit dem Heißschmelzkleber bzw. Binder bedeckten metallischen Bereiche der Folie mittels Druck und/oder Wärme auf ein Substrat aus Textil oder Leder übertragen werden. Hierbei handelt es sich um das klassische "hot melt"-Verfahren. Ein digitales Auftragen erfolgt hierbei nicht.

In der CH 677 905 wird ein Verfahren zur Herstellung einer mehrschichtigen Ausweiskarte mit Sicherheitsmerkmalen beschrieben. Das Substrat besitzt Lichtleiterstrukturen, die als Sicherheitsmerkmale dienen. Das Aufbringen der Tinte erfolgt mit mittels Digitaldruck. Mit dem digitalen Druckverfahren wird beispielsweise der Text, die fortlaufende Nummer, die Textur, die Adresse, das Bild und der Barcode auf das Substrat aufgebracht. Somit handelt es sich bei diesem digitalen Druckverfahren um ein klassisches Bedruckungsverfahren, das jedoch weder eine Metallfolienaufbringung noch eine digitale Aufbringung eines Haftvermittlers beschreibt.

In der DE 600 04 529 wird ein digitales Bedrucken unter Verwendung von lumineszierenden bzw. fluoreszierenden Tonern bzw. Tinten beschrieben. Eine Aufbringung von Metallfolien oder das digitale Aufbringen von Haftvermittlern wird nicht beschrieben. Es handelt sich vielmehr um ein konventionelles digitales Druckverfahren, wobei als Tinte lumineszierende bzw. fluoreszierende Tinten Verwendung finden, um die Sicherheltsdokumente zu bedrucken.

In der EP 1 049 588 wird ein Laminationsverfahren zur Herstellung einer mehrschichtigen Ausweiskarte aus Kunststoff beschrieben. Eine Aufbringung von Metallfolien oder metallisierten Folien ist nicht erwähnt. Ebenso wenig das digitale Aufbringen eines Haftvermittlers.

In der DE 103 30 421 wird ein Verfahren beschrieben, das mit einem Folienband arbeitet und der Herstellung von Hologrammen dient. Hierbei wird eine sogenannte Replizierschicht, die vorzugsweise aus einem transparenten, thermoplastischen Kunststoftmaterial besteht, mittels Linianraster tiefdruckweise aufgetragen und dann zur Trocknung in einem Trocknungskanal pe einer Temperatur von 100 bis 120 °C gelagert. In diese Replizierschicht wird mittels eines Trägerwerkzeuges eine Struktur eingeprägt. Das Härten des Lackes (Haftvermittlers) erfolgt mittels einer Lichtqualle. Das digitale Aufbringen eines Haftvermittlers wird nicht erwähnt

Bekannte Heißpräge- und Kaltprägeverfahren zum Aufbringen von Haftvermittlern besitzen den Nachteil, dass aufgrund der großen Partikelgröße beim Bedruckungsvorgang verhältnismäßig große Druckpunkte auf dem Substrat erzeugt werden. Diese Druckpunkte sitzen auf dem Substrat eng beieinander, so dass beim anschließenden Aufbringen der Metallfolie unter Einwirkung von Wärme ein wellenartiges Muster entsteht, was nachteilig ist.

In der EP 0 414 362 A wird ein Verfahren zur Herstellung von Leiterbahnen auf einem Substrat beschrieben. Das Verfahren verwendet einen Farbstoff, der auf ein Substrat über ein digitales Druckverfahren aufgebracht wird. Der Farbstoff umfasst einen Haftvermittler.

In der WO 03/020519 A1 wird ein digitales Druckverfahren beschirieben, bei dem dem Haftvermittler ein unter Tageslicht sichtbarer Farbstoff beigemengt wurde. Das Verfahren eigner sich zum Herstellen beliebiger Muster auf einem Substrat.

Vor diesem Hintergrund ist es Aufgabe der vorliegenden Erfindung, ein verbessertes Verfahren zum Herstellen eines Dekors oder eines optischen Sicherheitsmerkmals anzugeben, wodurch eindeutige Sicherheitsmerkmale geschaffen werden können, die über eine normale Bedruckung über das Muster der metallisierten Schicht hinausgehen.

Diese Aufgabe wird gelöst durch ein Verfahren mit den Merkmalen des Patentanspruchs 1.

Vorteilhafte Weiterbildungen ergeben sich aus den Unteransprüchen.

Bei dem erfindungsgemäßen Verfahren wird ein digitales Druckverfahren zum Aufbringen des Haftvermittlers eingesetzt. Dies hat den Vorteil, dass die bedruckte Partikelgröße verhältnismäßig klein ist und die Druckpunkte auf dem Substrat überlappend aufbringbar sind, wodurch eine geschlossene Oberfläche erzeugt wird.

Eine Überlappung von Punkten war bisher bei den bekannten analogen "Hot Melt"-Verlafahren zum Aufbringen des Haftvermittlers nicht möglich. Durch das erfindungsgemäße digitale Druckverfahren ist es erstmals möglich, eine nahezu glatte, ebene Schicht des Haftvermittlers auf dem Substrat zu erzeugen. Der Druckvorgang erfolgt dabei nahezu ohne Berührung, allenfalls erfolgt eine sogenannte "Kiss"-Berührung.

Ein weiterer Vorteil der Erfindung besteht darin, dass durch das digitale Verfahren ein Anlegen eines neuen Druckstockes zum Druck nicht mehr erforderlich ist. Mit Hilfe von digitalen Daten lässt sich ein individuelles Muster schnell und spezifisch erstellen.

Ein weiterer Vorteil besteht darin, dass verschiedene Tinten mit unterschiedlichen Wellenlängen zum Bedrucken verwendet werden können, beispielsweise das Erstellen eines Barcodes mit Infraret (IR)-Tinte.

Das erfindungsgemäße Verfahren ist darüber hinaus variabel und individualisierbar. Es eignet sich daher insbesondere für Sicherheitsprägungen bei Pässen und sonstigen Sicherheitsdokumenten. Mit dem erfindungsgemäßen Verfahren ist es möglich Kleinserien und individuelle partielle Metallisierungen wirtschaftlich sinnvoll vorzunehmen.

Ein weiterer großer Vorteil der Erfindung liegt in der Schnelligkeit und Flexibilität, mit der ein herzustellendes Muster umgesetzt oder verändert werden kann. Im Extremfall können Produkte hergestellt werden, von denen jedes ein Unikat darstellt, das heißt jedes Stück besitzt ein anderes Muster.

Das erlaubt die Anwendung der Erfindung in Verbindung mit personalisierten Dokumenten wie z.B. Ausweisen, Zugangs- und Berechtlgungskarten sowie Geld-, EC- und Kreditkarten. Sc ist es möglich, mit der Erfindung ein persönliches Bild, vorzugsweise in Form eines Hologramms, auf einem Dokument anzubringen, das gleichzeitig als optisches Sicherheitsmerkmal dient.

Die große Flexibilität in der Form des Musters bringt zudem Vorteile in der Entwicklungsphase für das Design eines Produkts oder dessen Verpackung, da ohne großen Aufwand mehrere Muster erstellt werden können, die dann dem Kunden zur Beurteilung zur Verfügung gestellt werden können. Die nachträgliche Überarbeitung und Einarbeitung von Änderungen nach den Wünschen des Kunden ist ohne Probleme realisierbar.

Ein weiteres Anwendungsgebiet ergibt sich beispielsweise für die MICR- bzw. die CMC7-Kodierung, die für Schecks im anglosächsischen und französischsprachigen Wirtschaftsraum überwiegend Anwendung lindet. Dabei wird magnetpartikelhaltige Farbe entweder über spezielle Drucktücher mit einem Anschlagsdrucker auf die Formulare gedruckt, oder es findet ein trockentonerbasiertes Digitaldruckverfahren mit speziellem Magnettoner Anwendung. Digitale Flüssigtonorverfahren und speziell auf InkJet basierende Verfahren können aber für diese Kodierungen mangels der Verfügbarkeit von magnetpartikelhaltigen Flüssigtonern bzw. magnetpartikelhaltigen InkJet-Tinten keine Anwendung finden.

Durch das erfindungsgemäße Druckverfahren können mittels einer Transfer-Metallfolie und einem der in der Erfindung benannten Digitaldruckverfahren solche MICR- bzw. CMC7-Kodierungen technisch einfach und wirtschaftlich kostengünstig vorgenommen werden.

So ist es ist bekannt, dass beispielsweise in den USA regulär über den Postweg versandte Schecks abgefangen werden und anschließend die Kodierzeile des Schecks so abgeändert wird, dass der richtige Betrag auf ein anderes Konto überwiesen wird. Da die Belastung des Geldbetrages auf dem Konto des Senders zunächst korrekt erscheint und die Mahnung des Empfängers sowie die daran anschließende Rückverfolgung der Zahlung in aller Regel erst deutlich später erfolgt, verbleibt für den Fälscher genug Zeit, den Geldbetrag auf das fälschlich genannte Konto umzuleiten, das Konto des Senders zu leeren und die Spuren des Kontoinhabers zu verwischen.

Durch die Beimengung von unter Tageslicht für das menschliche Auge unsichtbaren Farbstoffen und Farbpigmenten, wie z. B. fluoreszierenden oder lumineszierenden Farbstoffen zu dem digital bedruckbaren Haftvermittler werden Sicherheitselemete geschaffen , die eine Fälschung bzw. Verfälschung der kodierten Information leicht nachweisbar machen.

Die Erfindung ist ferner für den Einsatz bei kleineren und mittleren Stückzahlen prädestiniert, da keine hohen Fixkosten für die Herstellung von Prägewerkzeugen oder Druckwerkzeugen anfallen, die wiederum auf die Stückzahl umzulegen sind. Unter diesen Voraussetzungen ist die Erfindung somit auch in wirtschaftlicher Hinsicht den zuvor erwähnten analogen Verfahren überlegen.

Vorteilhafterweise wird in der vorliegenden Erfindung die metallische oder metallisierte Schichr auf eine Trägerfolie, beispielsweise aus Polyethylen (PE), aufgebracht. Dadurch kann die metallische oder metallisierte Schicht für die Applikation auf das Substrat optimiert werden, während die Trägerschicht für die mechanische Festigkeit zur Durchführung des erfindungsgemäßen Verfahrens sorgt. Auf diese Weise wird die Betriebssicherheit des erfindungsgemäßen Verfahrens deutlich erhöht. In einfacher Art lässt sich eine solche Prägefolie herstellen, indem auch die metallische oder metallisierte Schicht aus einer Folie besteht, die deckungsgleich mit der Trägerfolie zusammengefügt ist.

Durch die Ausbildung des Substrats in Form einer Bahn werden die Voraussetzungen geschaffen, um einen möglichst effektiven Herstellungsvorgang zu erreichen. So können sowohl das Substrat als auch die Prägefolie auf Rollen in dem erfindungsgemäßen Verfahren eingesetzt werden. Dies erlaubt zudem eine Durchführung des Verfahrens als sogenanntes "Inline-Verfahren", wodurch hohe Produktionsgeschwindigkeiten erreichbar sind.

Vorzugsweise wird die Prägefolie nach dem Zusammenfügen mit dem Substrat in einer Kontaktierungsstation auf das Substrat gedrückt. Dadurch wird sichergestellt, dass die metallische oder metallisierte Schicht vollflächig im Bereich des Haftvermittlers aufliegt, so dass das Muster vollständig auf das Substrat appliziert wird. Eine unmittelbare Anordnung der Kontaktierungsstation nach dem Zusammenfügen der Prägefolie und des Substrats wirkt einer Faltenbildung und damit optischen Beeinträchtigung des Musters entgegen.

Durch die Beimengung von Farbpigmenten zum Haftvermittler ist es vor allem in Verbindung mit durchscheinenden metallischen oder metallisierten Folien möglich, neue, die Aufmerksamkeit potentieller Käufer erweckende Farbeffekte zu erzeugen.

Hinsichtlich der zur Durchführung des erfindungsgemäßen Verfahrens notwendigen Haftvermittler bestehen mehrere Möglichkeiten. So kann ein Haftvermittler, beispielsweise ein radikalisch oder kationisch härtender Kleber, zur Anwendung kommen, dessen Moleküle durch Bestrahlung mit UV-Licht vernetzt werden.

Die Anwendung dieser Verfahren sorgt für eine gleichmäßige Verklebung der metallischen oder metallisierten Schicht mit dem Substrat weitgehend unabhängig von der Zeitspanne zwischen dem Auftrag des Haftvermittlers und der Belegung des Substrats mit der Prägefolie.

Die Aktivierung des Haftvermittlers erfolgt vorteilhafterweise bei gleichzeitigem Anpressen der metallischen oder metallisierten Schicht auf das Substrat. Dadurch wird das Verkleben der metallischen oder metallisierten Schicht mit dem Substrat und damit der Transfer auf das Substrat weiter verbessert.

In vorteilhafter Weiterbildung der Erfindung ist ferner vorgesehen, ein Ablösen der Prägefolie von der Substratoberfläche in einem möglichst flachen Winkel durchzuführen. Das verbessert die Trennschärfe der metallischen oder metallisierten Schicht am Randbereich des herzustellenden Musters.

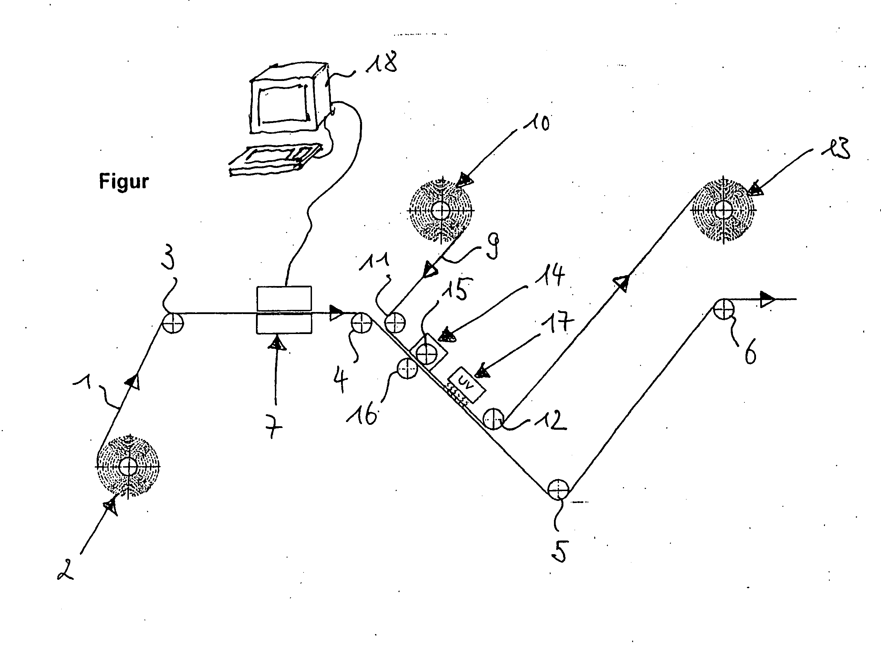

Die Erfindung wird nachstehend anhand eines in der Zeichnung dargestellten Ausführungsbeispiels näher erläutert.

Die einzige Figur zeigt in schematischer Darstellung die verschiedenen Verfahrensschritte bzw. Bearbeitungsstationen einer zur Durchführung des Verfahrens geeigneten Vorrichtung.

In der Figur sieht man zunächst das Substrat 1, das als Papierbahn vorliegt und die Vorrichtung in Richtung der Pfeile durchläuft. Zu diesem Zweck wird das bahnförmig vorliegende Substrat 1 in einer Abwickelstation 2 von einer Rolle abgewickelt und den verschiedenen Bearbeitungsstationen zugeführt, bevor es in der Figur nicht dargestellte nachfolgende Bearbeitungsstationen wie z.B. Lackier- oder Schneidstationen erreicht. Bei seinem Durchgang durch die Vorrichtung ist das Substrat 1 über verschiedene Umlenkrollen 3 bis 6 geführt, wobei die Abschnitte zwischen den Umlenkrollen 3 bis 6 eine oder mehrere Bearbeitungsstationen aufweisen. So sieht man zwischen der Umlenkrolle 3 und Umlenkrolle 4 eine digitale Druckstation 7 in Form eines Tintenstrahldruckers. Das Substrat 1 durchläuft die digitale Druckstation 7 und wird dabei im Bereich des herzustellenden Musters mit einem Haftvermittler digital bedruckt.

Die Konturen und Flächen des herzustellenden Musters oder Dekors sind zuvor an einem Computer 18 mittels geeigneter Programme erstellt und daraus ein musterspezifischer digitaler Datensatz erstellt worden. Mit Hilfe des Datensatzes wird die digitale Druckstation 7 gesteuert.

Das eigentliche Applizieren eines Musters auf das Substrat 1 geschieht in dem Abschnitt zwischen den Umlenkrollen 4 und 5. Dort sieht man eine Prägefolie 9, die von einer Abwickelstation 10 über die Umlenkrollen 11 und 12 zu einer Aufwickelstation 13 läuft. Zwischen den Umlenkrollen 11 und 12 ist die Prägefolie 9 planparallel und deckungsgleich mit dem Substrat 1 geführt. In diesem Bereich sieht man eine Kontaktierungsstation 14, die sich im Wesentlichen aus zwei gegenläufigen und zusammenwirkenden Anpressrollen 15 und 16 zusammensetzt, zwischen denen das Substrat 1 mit darüber liegender Prägefolie 10 durchläuft. Dabei wird sichergestellt, dass die Prägefolie 10 am Substrat 1 unter Kontakt anliegt. Unmittelbar danach gelangen Substrat 1 und Prägefolie 10 in eine Belichtungsstation 17, wo sin einer UV-Strahlung ausgesetzt sind. Die UV-Strahlung bewirkt eine Aktivierung des in der digitalen Druckstation 7 auf das Substrat 1 aufgedruckten Haftvermittlers, so dass eine Verklebung von Substrat 1 und Prägefolie 10 im Bereich des Haftvermittlers erfolgt. Bevorzugt ist dabei eine Anpressstation - nicht dargestellt - im Bereich der Belichtungsstation 17, um eine Verklebung der beiden Bahnen 1 und 9 unter Druck zu erreichen.

Danach wird mit Hilfe der Umlenkrolle 12 die Prägefolie 9 vom Substrat 1 abgehoben. Die naturgemäß spröde Prägefolie 9 bricht dabei an den Kleberändern, die der Umrisslinie des herzustellenden Musters entsprechen. Über die Umlenkrollen 5 und 6 wird das so veredelte Substrat 1 weiteren Bearbeitungsstationen, wie zum Beispiel einer Lackier- oder Schneidstation, zugeführt.

## Patentansprüche

1. Verfahren zum Herstellen eines Dekors oder optischen Sicherheitsmerkmals aus einer metallischen oder metallisierten Folie auf der Oberfläche eines Substrats (1) zur Erzeugung von individuellen Mustern oder Sicherheitselementen, wobei
- zunächst ein digitaler, das Muster beschreibender Datensatz erstellt wird,
- dann unter Verwendung des digitalen Datensatzes mit Hilfe eines digitalen Druckverfahrens ein mittels UV-Licht aktivierbarer Haftvermittler bereichsweise und passerhaltig mit dem herzustellenden Muster auf die Oberfläche des Substrats (1) digital gedruckt wird, so dass eine Überlappung der Druckpunkte erreicht wird, wodurch der Haftvermittler als glatte, ebene Schicht auf dem Substrat (1) aufgetragen ist,
- dann die metallische oder metallisierte Folie großflächig und mit Kontakt auf die Oberfläche des Substrats (1) aufgebracht wird,
- dann der Haftvermittler mittels UV-Licht aktiviert wird, um ein Verkleben der metallischen oder metallisierten Folie mit der Oberfläche des Substrats (1) im Bereich des herzustellenden Musters zu erreichen,
- dann die metallische oder metallisierte Folie großflächig abgehoben wird, wobei die verklebten Bereiche auf dem Substrat (1) zurückbleiben, wobei dem Haftvermittler unter Tageslicht unsichtbare Farbpigmente, Farbstoffe, Lumineszenzfarbstoffe, Fluoreszenzfarbstoffe sowie andere maschinell detektierbare unsichtbare Stoffe beigemengt werden.

2. Verfahren nach Anspruch 1, **dadurch gekennzeichnet, dass** die metallische oder metallisierte Folie in einem vorhergehenden Arbeitsschritt auf eine Trägerfolie aufgebracht und im Verbund mit der Trägerfolie dem Substrat (1) zugeführt wird.

3. Verfahren nach einem der Ansprüche 1 bis 2, **dadurch gekennzeichnet, dass** als digitales Druckverfahren das Elektrografie-, lonografie-, Magnetografie-, Thermografie- oder InkJet-Verfahren zur Anwendung kommt.

4. Verfahren nach einem der Ansprüche 1 bis 3, **dadurch gekennzeichnet, dass** mit oder nach dem Auftragen der metallischen oder metallisierten Folie auf die Oberfläche des Substrats (1) ein Andrücken der metallischen oder metallisierten Folie auf das Substrat (1) erfolgt.

5. Verfahren nach Anspruch 4, **dadurch gekennzeichnet, dass** das Andrücken unmittelbar nach dem Auftrag des Haftvermittlers erfolgt.

6. Verfahren nach einem der Ansprüche 1 bis 5, **dadurch gekennzeichnet, dass** während der Aktivierung des Hattvermittlers ein Anpressen der metallischen oder metallisierten Folie auf das Substrat (1) erfolgt.

7. Verfahren nach einem der Ansprüche 1 bis 6, **dadurch gekennzeichnet dass** das Abheben der metallischen oder metallisierten Folie vom Substrat (1) unter einem flachen Winkel erfolgt.

## Claims

1. A process of producing a decoration or optical security feature comprising a metallic or metallised foil on the surface of a substrate (1) to create individual patterns or security elements, wherein
- firstly, a digital data record describing the pattern is created,
- then using the digital data record an adhesion promoter, which can be activated by UV light, is printed digitally by means of a digital printing process on to the surface of the substrate (1) zonally and so as to maintain register with the pattern to be produced, so that overlapping of the print points is achieved, whereby the adhesion promoter is applied as a smooth, even layer on the substrate (1),
- then the metallic or metallised foil is applied over a large area and with contact on to the surface of the substrate (1),
- then the adhesion promoter is activated by means of UV light so as to achieve gluing of the metallic or metallised foil with the surface of the substrate (1) in the vicinity of the pattern to be produced,
- then the metallic or metallised foil is removed over a large area, the glued areas remaining on the substrate (1), wherein coloured pigments, dyes, fluorescent dyes and other machine-detectable invisible materials, which are invisible in daylight, are added to the adhesion promoter.

2. A process according to Claim 1, **characterised in that**, in a previous operating stage, the metallic or metallised foil is applied to a support foil and is fed together with the support foil to the substrate (1).

3. A process according to Claim 1 or 2, **characterised in that** an electrophotographic, ionographic, magnetographic, therographic or inkjet process is used as the digital printing process.

4. A process according to any one of Claims 1 to 3, **characterised in that** pressing of the metallic or metallised foil on to the substrate (1) takes place with or after the application of the metallic or metallised foil on to the surface of the substrate (1).

5. A process according to Claim 4, **characterised in that** the pressing takes place immediately after the application of the adhesion promoter.

6. A process according to any one of Claims 1 to 5, **characterised in that**, during the activation of the adhesion promoter, pressing of the metallic or metallised foil on to the substrate (1) takes place.

7. A process according to any one of Claims 1 to 6, **characterised in that** the removal of the metallic or metallised foil from the substrate (1) takes place at a shallow angle.

## Revendications

1. Procédé pour, afin de produire des dessins ou des éléments de sécurité individuels, réaliser sur la surface d'un substrat (1) un décor ou une caractéristique de sécurité optique à partir d'un film métallique ou métallisé, selon lequel
- on génère tout d'abord un jeu de données numériques décrivant le dessin,
- ensuite, en utilisant le jeu de données numériques et à l'aide d'un procédé d'impression numérique, un promoteur d'adhérence activable au moyen de lumière UV est imprimé numériquement sur la surface du substrat (1) sectoriellement en ajustement exact avec le dessin à réaliser, de telle sorte qu'on obtient un chevauchement des points d'impression, de sorte que le promoteur d'adhérence est appliqué sur le substrat (1) sous la forme d'une couche lisse et plane,
- ensuite, on applique le film métallique ou métallisé sur la surface du substrat (1), sur toute la surface et en contact,
- ensuite, on active le promoteur d'adhérence au moyen de lumière UV, afin d'obtenir un assemblage par collage du film métallique ou métallisé avec la surface du substrat (1) dans la région du dessin à réaliser,
- ensuite, on enlève le film métallique ou métallisé sur toute la surface, les régions collées restant sur le substrat (1),
sachant qu'on ajoute au promoteur d'adhérence des pigments colorés, des colorants, des colorants luminescents et des colorants fluorescents, invisibles à la lumière du jour, ainsi que d'autres substances invisibles pouvant être détectées par machine.

2. Procédé selon la revendication 1, **caractérisé en ce qu'**au cours d'une étape préalable, le film métallique ou métallisé est appliqué sur un film de support, et apporté au substrat (1) conjointement avec le film de support.

3. Procédé selon la revendication 1 ou 2, **caractérisé en ce qu'**on utilise comme procédé d'impression numérique le procédé d'électrographie, d'ionographie, de magnétographie, de thermographie ou à jet d'encre.

4. Procédé selon l'une des revendications 1 à 3, **caractérisé en ce qu'**avec ou après l'application du film métallique ou métallisé sur la surface du substrat (1), on presse le film métallique ou métallisé sur le substrat (1).

5. Procédé selon la revendication 4, **caractérisé en ce que** la pression s'effectue directement après l'application du promoteur d'adhérence.

6. Procédé selon l'une des revendications 1 à 5, **caractérisé en ce que**, pendant l'activation du promoteur d'adhérence, on presse le film métallique ou métallisé en contact sur le substrat (1).

7. Procédé selon l'une des revendications 1 à 6, **caractérisé en ce que** le film métallique ou métallisé est enlevé du substrat (1) sous un angle plat.
